Europäisches Patentamt

European Patent Office

Office européen des brevets

(19)

(11) Veröffentlichungsnummer: **0 401 746**
**A2**

# (12) EUROPÄISCHE PATENTANMELDUNG

(21) Anmeldenummer: **90110609.6**

(51) Int. Cl.⁵: **H01L 21/56**

(22) Anmeldetag: **05.06.90**

(30) Priorität: **05.06.89 DE 3918315**

(43) Veröffentlichungstag der Anmeldung:
**12.12.90 Patentblatt 90/50**

(84) Benannte Vertragsstaaten:
**DE FR GB IT NL**

(71) Anmelder: **Siemens Aktiengesellschaft**
**Wittelsbacherplatz 2**
**D-8000 München 2(DE)**

(72) Erfinder: **Manus, Patrick, Mc. Dipl.-Chem.**
**St. Cajetan Strasse 10**
**D-8000 München 80(DE)**
Erfinder: **Kutscherauer, Rudolf**
**Am Mitterfeld 8**
**D-8011 Forstern(DE)**

(54) **Verfahren zum Umhüllen eines elektronischen Bauelementes und Vorrichtung zur Durchführung dieses Verfahrens.**

(57) Zur Bildung einer kompressiblen Zwischenschicht (7) zwischen Chip (1) und Hülle (21) wird vorgeschlagen, ein UV-härtbares Gel mit einr Mehrfachnadel (8-13) aufzudosieren. Die Mehrfachnadel wird dabei mit wechselnden Bewegungsrichtungen und u. U. auch variierten Geschwindigkeiten über die Chipfläche geführt. Nach dem Auftragen wird die Schicht vorgehärtet, und zwar auf einem der Mehrfachnadel in bestimmtem Abstand nachgeführten Streifen (20).

**FIG 2**

EP 0 401 746 A2

## Verfahren zum Umhüllen eines elektronischen Bauelementes und Vorrichtung zur Durchführung dieses Verfahrens.

Die Erfindung bezieht sich auf ein Verfahren gemäß dem Oberbegriff des Anspruchs 1. Eine solche Umhüllungstechnik wird in der veröffentlichten europäischen Patentanmeldung 88 11 3887.9 beschrieben.

Empfindliche Bauelemente wie komplexe integrierte Schaltungen werden in der Regel mit einer Kunststoffmasse umhüllt, um sie vor Umgebungseinflüssen zu schützen. Die bisher entwickelten Hüllmassen können das Bauelement zwar zuverlässig vor Atmosphärilien abschirmen, sind aber thermisch nicht sonderlich gut an das Chipmaterial angepaßt, so daß es insbesondere bei stark schwankenden Betriebstemperaturen zu unzulässig hohen Spannungen kommen kann. Man ist deshalb dazu übergegangen, die Chipoberfläche mit einer elastischen und kompressiblen Zwischenschicht abzudecken, die thermische Ausdehnungsunterschiede zuläßt und somit auch eine größere Auswahl unter den verschiedenen Hüllkunststoffen ermöglicht.

Für diese Zwischenschicht schlägt die eingangs zitierte Offenlegungsschrift verschiedene Materialien und Aufbringverfahren vor, beispielsweise den manuellen Auftrag eines UV-härtenden Silikonkautschuks oder das Aufdosieren eines Polyetherurethans. Um das Aufdosieren flächendeckend zu gestalten, ist dabei vorgesehen, die Zwischenschichtmasse durch eine mäanderförmig über den Chip geführte Hohlnadel oder durch eine schlitzförmige Düse zu pressen.

Die Praxis hat gezeigt, daß die in der erwähnten Veröffentlichung beschriebenen Substanzen und Aufbringtechniken bei kleinflächigen Chips zu durchaus befriedigenden Ergebnissen führen. Bei Chipflächen von etwa 1 cm$^2$ oder mehr gelingt es dagegen nicht mehr ohne weiteres, die Randbereiche, die an sich wegen ihrer empfindlichen Bonddrahtkontaktierungen auf einen besonderen Schutz vor mechanischen Einwirkungen angewiesen wären, zuverlässig abzudecken. Das liegt vor allem daran, daß sich die aufgebrachten Kunststoffe aufgrund ihrer Oberflächenspannung relativ rasch zu einer Tropfenform zusammenziehen. Ein weiterer Nachteil tritt hinzu, wenn das umhüllte Bauelement auch noch flach sein soll: die zusammengeflossene Zwischenschicht wird zur Chipmitte hin so dick, daß sie unter Umständen von der Hüllmasse nicht mehr überzogen wird und dann mehr oder weniger stark hervortritt. Das Bauelement ist in diesem Fall lokal nicht mehr vollständig verkapselt und hat überdies nicht mehr die vorgeschriebene Bauform.

Theoretisch gibt es mehrere Möglichkeiten, die erwähnte Tropfenbildung zu verhindern oder zu beseitigen. So könnte man die Zwischenschicht in einer Spritzgußtechnik realisieren (ältere, noch nicht veröffentlichte deutsche Patentanmeldung P 38 33 276.0). Diese Technik ermöglicht ein wohldefiniertes Schichtenprofil und läßt sich zudem automatisieren. Sie verlangt allerdings relativ kompliziert aufgebaute Spritzgußwerkzeuge, ist recht zeitraubend und gestattet es nicht ohne weiteres, die Schicht nur auf die Chipoberfläche zu begrenzen. So sind in der Patentanmeldung P 38 33 276 die kompletten Bonddrähte einschließlich ihrer Kontakte mit den Anschlußbeinen beschichtet, eine Ausgestaltung, die bei bestimmten Chiptypen strikt vermieden werden muß.

Denkbar wäre es auch, die Schichtsubstanz auf das Zentrum der zu beschichtenden Fläche zu tropfen und dann durch Rotation des Bauelementes zu verteilen (DE- AS 26 37 105). Schließlich gäbe es noch entsprechend der DE-OS 34 42 131 die Alternative, den Chip mit einer siegelfähigen Substanz zu übergießen und diese Masse dann mit einer unter erhöhten Temperaturen aufgepreßten Folie in die gewünschte Form zu bringen. Es liegt auf der Hand, daß beide Verfahren so aufwendig sind, daß sie für eine Massenproduktion eigentlich nicht infrage kommen.

Der Erfindung liegt daher die Aufgabe zugrunde, bei einem Verfahren der eingangs genannten Art die Zwischenschicht derart aufzubringen, daß sie die gesamte Chipoberfläche bis in deren Ecken hinein abdeckt und dabei ein relativ ebenes Profil wahrt. Das Aufbringverfahren soll dabei zuverlässig sein, mit einem möglichst geringen Überschuß an Schichtmasse auskommen und sich nicht zuletzt für eine Fertigung in industriellem Maßstab eignen.

Diese Aufgabe wird erfindungsgemäß durch ein Verfahren mit den Merkmalen des Patentanspruchs 1 gelöst.

Versuche haben gezeigt, daß die erfindungsgemäß vorgesehene Aufdosierung, bei der mehrere Aufbringstellen kollektiv und in einem bestimmten Bewegungsmuster über die Chipoberfläche geführt und in einem vorgegebenen Zeitabstand von einer UV-Härtung begleitet werden, Schichtenprofile ergeben, die auch hohen Anforderungen bezüglich ihrer Mindeststärke im Kantenbereich und zulässigen Maximaldicke über dem Flächenzentrum genügen. Die Dosiertechnik ist dabei so schonend, daß die Bonddrahtkontakte nicht angegriffen werden. Sämtliche Einzelschritte sind automatisierbar und lassen sich zu einem vollautomatischen Verkapselungsprozeß erweitern. Insgesamt kann man die Zwischenschicht in weniger als 10 Sekunden realisieren, und zwar insbesondere dann, wenn man die UV-Härtung in einem ersten Schritt nur so weit durchführt, daß das Schichtmaterial seine Fließfähigkeit verliert, und dann in einem zweiten Schritt mehrere Bauelemente, etwa alle Chips eines "lead frames", gleichzeitig aushärtet, ein Vorgang, der typischerweise noch einmal 20 Sekunden benötigt.

Abhängig von den Umständen des Einzelfalles kann es sich empfehlen, die einzelnen Parameter des erfindungsgemäß vorgesehenen Verfahrens zu modifizieren. So kann es sinnvoll sein, die Düsenreihe auch noch oberhalb der Stopkante parallel zu dieser Kante hin- und herzuführen. Darüberhinaus ist es häufig zweckmäßig, den Gelaustritt ein- oder auch mehrmals zu unterbrechen, beispielsweise für ein kurzes Stück zu Beginn des zweiten Teilschritts, bei dem die Düsenreihe über die Chipfläche geführt wird. Ferner bietet es sich mitunter an, die Geschwindigkeit der über den Chip geführten Düsenreihe zu variieren. Häufig erzielt man dabei beste Resultate, wenn man mit einer relativ hohen Geschwindigkeit startet, anschließend zu einer geringeren Geschwindigkeit übergeht und dann, wenn der größte Teil des Chips bereits überzogen ist, die Geschwindigkeit wieder erhöht.

Das erfindungsgemäß vorgesehene Verfahren läßt sich besonders einfach durchführen, wenn die Düsen - in der Regel Hohlnadeln -mit der für die Vorhärtung verwendeten UV-Lichtquelle in einem festen räumlichen Abstand, beispielsweise auf einem gemeinsamen Schlitten, angebracht sind.

Weitere vorteilhafte Ausgestaltungen und Weiterbildugen der Erfindung sind Gegenstand zusätzlicher Ansprüche.

Die Erfindung soll nun anhand eines Ausführungsbeispiels unter Bezugnahme auf die Figuren der beigefügten Zeichnung näher erläutert werden. In den Figuren sind dabei einander entsprechende Teile mit gleichen Bezugszeichen versehen. Es zeigen:

Fig. 1 in einer Draufsicht einen Chip, der bereits mit einer Zwischenschicht überzogen, aber noch nicht vereinzelt ist; Systemträger und Anschlußbeine sind dabei teilweise weggebrochen;

Fig. 2 den Chip der Figur 1 im Schnitt II - II, nach seiner Umhüllung und Vereinzelung; und

Fig. 3 anhand eines von oben gesehenen, nur schematisch dargestellten Chips die Abfolge der verschiedenen Teilschritte bei einem erfindungsgemäßen Verfahren zur Herstellung der Zwischenschicht.

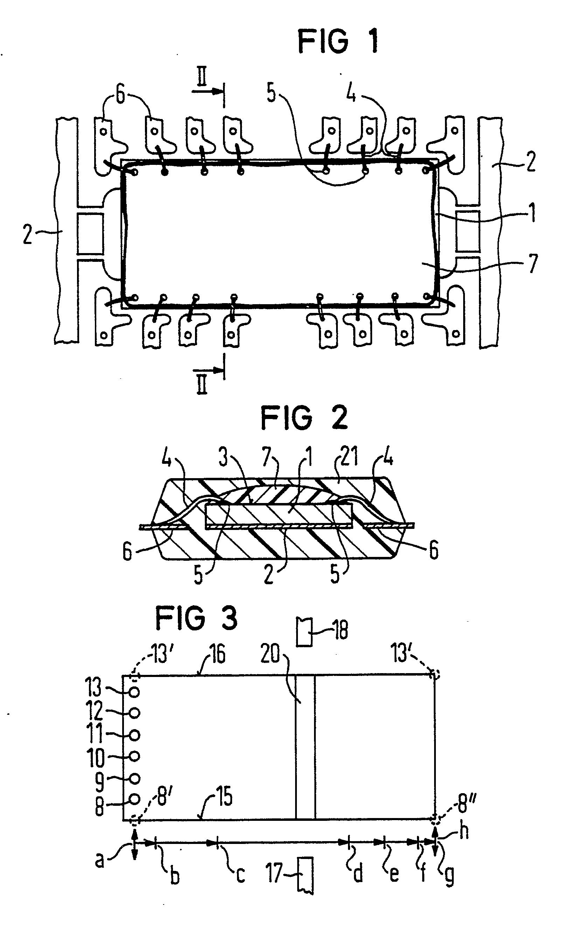

Das in den Figuren 1 und 2 dargestellte Bauelement ist ein umhüllter 4 Mbit Speicher. Der eigentliche Speicher 1, ein Chip mit einer Grundfläche von 15 x 7 mm Kantenlänge, ist auf einem Systemträger 2 fixiert. Von der dem Systemträger 2 abgewandten Oberfläche 3 des Speichers 1 gehen an den Kanten und Ecken Bonddrähte 4 aus, die jeweils mit ihrem einen Ende, und zwar in einem Nailhead 5, den Chip kontaktieren und mit ihrem anderen Ende mit einem Anschlußbein 6 in Kontakt stehen. Die gesamte Chipoberfläche 3 ist mit einer Zwischenschicht 7 überzogen, die die Nailheads 5 mit einer gewissen Mindeststärke bedeckt und zur Chipmitte hin nur relativ schwach aufgewölbt ist. Die gesamte Anordnung ist mit einer Hülle 21 verkapselt, aus der lediglich die Anschlußbeine 6 herausragen.

Die Zwischenschicht wird folgendermaßen realisiert:

Zunächst legt man den Chip 1, der in der Regel noch mit weiteren Chips in einem bandförmigen "lead frame" eingebaut ist, unter einen Gel-Dispenser. Dieser Dispenser enthält sechs in einer Reihe nebeneinander angeordnete Hohlnadeln 8 bis 13 (Fig. 3) Die Nadeln sind derart voneinander beabstandet, daß sie nahezu die gesamte Schmalseite (Kante 14) der unter ihr liegenden Chipfläche abdecken.

Der Dispenser ist mit einem Gel gefüllt, das von der Fa. Dow Corning unter der Bezeichnung "DC 7551-70Q" vertrieben wird. Dieses Gel ist ein lösungsmittelfreies Einkomponenten-Silicon, das unter UV-Licht aushärtet.

Vor Beginn der Gelabgabe werden die Nadeln auf einen definierten Abstand zu den Bonddrahtbögen abgesenkt. Dann wird das Gel mit einem definierten Druck durch die Hohlnadeln gepreßt.

Der Prozeßablauf wird in Abhängigkeit von der Chipfläche und dem Design empirisch ermittelt. Eine wesentliche Rolle spielen dabei, wie bereits erwähnt, die Bewegungsrichtungen und Geschwindigkeiten der Mehrfachnadel, die Ein- und Ausschaltzeiten des Dispensers und die räumlich/zeitliche Positionierung der nachgeführten UV-Lichtquelle.

Im vorliegenden Beispiel wird die oberhalb der Startkante 14 befindliche Mehrfachnadel nach dem Einschalten des Dispensers zunächst entlang der Startkante, die auch parallel zur Erstreckungsrichtung der Düsenreihe verläuft, hin- und herbewegt (Doppelpfeil a). Der Hub dieser Bewegung ist so groß, daß die äußeren Hohlnadeln 8 und 13 jeweils über die rechtwinklig zur Startkante 14 verlaufenden Chipkanten 15, 16 gelangen (Positionen 8' bzw. 13').

Nach diesem ersten Teilschritt wird die Nadelreihe längs der Kanten 15, 16 mit einer relativ hohen Geschwindigkeit $V_1$ geführt, wobei der Dispenser zunächst eine gewisse Zeit, in der sich die Nadelreihe bis zum Punkt b bewegt, ausgeschaltet ist. Daß man den Dispenserimpuls hier unterbricht, liegt vor allem daran, daß das im ersten Teilschritt reichlich aufgetragene Gel zerfließt und dadurch auch auf der benachbarten Chipfläche - mit einer mit wachsendem Abstand von der Startkante abnehmenden Wirkung -Schichtmaterial ablagert.

Im folgenden Teilschritt, der bei Punkt c endet, ist der Dispenser - unter Beibehaltung der Bewegungsgeschwindigkeit $V_1$ - wieder eingeschaltet. Im anschließenden, bei Punkt d abgeschlossenen Teilschritt ist die Bewegungsgeschwindigkeit auf einen kleineren Wert $v_2$ gedrosselt. Die Reduzierung der Geschwindigkeit ist deshalb erforderlich, weil in diese Flächenzone aus dem Kantenbereich kein zusätzliches Gel mehr gelangt.

In einem nächsten Teilschritt, bei dem die Nadelreihe bis zum Punkt e kommt, wird die UV-Lichtquelle eingeschaltet. Diese Quelle ist ein mit zwei Lichtleitern 17,18 versehener, UV-Punktstrahler. Das Spektrum dieses Strahlers ist mit einem Filter auf einen auf das verwendete Gel abgestimmte Wellenlängenbereich eingeengt. Die Lichtleiter dieses Geräts sind in einem definierten Abstand über dem System positioniert. In dieser Position bestrahlen sie die Zwischenschicht in einem parallel zur Startkante 14 verlaufenden Streifen 20. Beide Lichtleiter werden mit der gleichen Geschwindigkeit wie die Nadelreihe über die Chipfläche geführt und sind so eingestellt, daß sie den bestrahlten Gelstreifen vorhärten, d. h. an einem weiteren Zerfließen hindern. Im Augenblick des Einschaltens der UV-Quelle befindet sich der Streifen im Bereich der Kante 14.

Während die Nadelreihe vom Punkt e bis zu einem Punkt f wandert, wird ihre Bewegungsgeschwindigkeit auf den ursprünglichen Wert $v_1$ heraufgesetzt. Auf der letzten Teil strecke d. h. bis zum Erreichen des Punktes g auf der der Startkante gegenüberliegenden Chipkante 19 ("Stopkante"), werden die Gelzufuhr gestoppt und die Nadelgeschwindigkeit wieder auf den Wert $v_2$ reduziert. Diese Geschwindigkeitsvariation dient der weiteren Einebnung der Schichtdicke. Oberhalb der Stopkante ändert sich die Bewegungsrichtung: Die Nadeln werden nun wie im ersten Teilschritt parallel zu den Kanten 14 und 19 hin- und herbewegt, (Doppelpfeil h), so daß die äußeren Nadeln 8 und 13 die Positionen 8″ und 13″ erreichen. Anschließend zieht man die Nadeln hoch. Wenn auch der den Nadeln nachgeführte Belichtungsstreifen die Stopkante überfahren hat, wird das UV-Licht ausgeschaltet. Dann werden der Dispenser und die UV-Quelle längs der Kanten 15 und 16 in ihre Ausgangsstellungen zurückgefahren. Zugleich wird der Chip 1 längs der Kanten 14 und 19 weitertransportiert, so daß der benachbarte Chip unterhalb der Nadelreihe zu liegen kommt.

Wenn alle Chips eines lead frames beschichtet sind, werden sie zusammen mit einer UV-Lampe in etwa 20 sec. endgültig ausgehärtet. Anschließend verkapselt man in üblicher Weise die Chips des lead frames mit einer duro- oder thermoplastischen Masse und vereinzelt schließlich die Bauelemente.

Eine Reihe von Tests haben ergeben, daß die so hergestellten Zwischenschichten oberhalb der besonders kritischen Höcker an den Chipecken regelmäßig eine bestimmte Mindestdicke aufweisen und in der Chipmitte stets unter einer definierten Maximaldicke liegen.

Das erfindungsgemäß vorgesehene Verfahren beschränkt sich nicht nur auf das detailliert geschilderte Ausführungsbeispiel. So kommt es auch für andere Bauelemente, u. U. sogar auch für Hybridschaltungen, infrage. Dabei bleibt es dem Fachmann unbenommen, die Zwischenschicht noch mit einer weiteren Schicht, die etwa aus Polyimid bestehen könnte, zu unterfüttern.

**Ansprüche**

1. Verfahren zum Umhüllen eines elektronischen Bauelementes, das die Form einer Platte mit zwei gegenüberliegenden Grundflächen hat, wobei von einer der beiden Grundflächen ("Deckfläche"), und zwar zumindest im Bereich ihrer Ecken, Bonddrähte ausgehen,
mit folgender Schrittfolge:
a) auf die Deckfläche wird ein fließfähiges, zu einer elastischen und kompressiblen Masse aushärtbares Gel aufgetragen; das Gel tritt dabei durch mindestens eine Düse, die in verschiedenen Richtungen derart über die Deckfläche geführt wird, daß das Gel eine flächendeckende Schicht ("Zwischenschicht") bildet;
b) die Zwischenschicht wird zumindest so weit vorgehärtet, daß sie ihre Fließfähigkeit verliert;
c) das mit der Zwischenschicht versehene Bauelement wird mit einer Hüllmasse umschlossen;
**dadurch gekennzeichnet,**
daß das Gel UV-härtbar ist,
daß mehrere in einer Reihe ("Ausrichtungsachse") nebeneinanderliegende Düsen verwendet werden,
daß im Schritt a)
a1) zunächst die Düsenreihe oberhalb einer der Kanten ("Startkante") hin- und hergeführt wird, und zwar längs ihrer Ausrichtungsachse, die zugleich parallel zur Startkante verläuft, und
a2) anschließend die Düsenreihe über die Deckfläche hinweg bis zu der der Startkante gegenüberliegenden Deckflächenkante der ("Stopkante") geführt wird, und
daß im Schritt b) die Zwischenschicht durch Bestrahlung mit UV-Licht in einem parallel zur Startkante erstreckten Streifen gehärtet wird, der in einem vorgegebenen räumlichen Abstand zur Düsenreihe ebenfalls von der Startkante bis zur Stopkante über die Deckfläche geführt wird.

2. Verfahren nach Anspruch 1, **dadurch gekennzeichnet,** daß die Düsenreihe in einem Teilschritt a3) auch noch oberhalb der Stopkante parallel zu ihrer Ausrich tungsachse hin- und hergeführt wird.

3. Verfahren nach Anspruch 1 oder 2, **dadurch gekennzeichnet,** daß zu Beginn des Teilschritts a2) kein Gel aus den Düsen austritt.

4. Verfahren nach einem der Ansprüche 1 bis 3, **dadurch gekennzeichnet,** daß während des Teilschritts a3) kein Gel aus den Düsen austritt.

5. Verfahren nach einem der Ansprüche 1 bis 4, **dadurch gekennzeichnet,** daß die Geschwindigkeit, mit der die Düsen über die Deckfläche geführt werden, variiert wird.

6. Verfahren nach Anspruch 5, **dadurch gekennzeichnet,** daß die Geschwindigkeit im Laufe des Teilschritts a2) zunächst vermindert und dann wieder erhöht wird.

7. Verfahren nach einem der Ansprüche 1 bis 6, **dadurch gekennzeichnet,** daß die Zwischenschicht im Schritt b) lediglich vorgehärtet wird und daß anschließend das Bauelement zusammen mit weiteren, ebenfalls jeweils mit einer vorgehärteten Zwischenschicht versehen Bauelementen im gleichen Arbeitsgang endgültig ausgehärtet wird.

8. Vorrichtung zu Durchführung eines Verfahrens gemäß einem der Ansprüche 1 bis 7, **dadurch gekennzeichnet,** daß sie einen ersten Schlitten enthält, auf dem die Düsen und die vorhärtende UV-Lichtquelle in einem festen räumlichen Abstand zueinander montiert sind.

9. Vorrichtung nach Anspruch 8, **dadurch gekennzeichnet,** daß sie einen zweiten, den Chip tragenden Schlitten enthält, daß der erste Schlitten nach erfolgter Vorhärtung wieder in seine Ausgangsposition, bei der die Düsenreihe oberhalb der Startkante zu liegen kommt, zurückgeführt wird und daß der zweite Schlitten während der Rückführung des ersten Schlittens das mit einer Zwischenschicht versehene Bauelement parallel zur Startkante weitertransportiert und zugleich ein neues Bauelement in Position bringt.

10. Vorrichtung zur Durchführung eines Verfahrens nach einem der Ansprüche 1 bis 7, **dadurch gekennzeichnet,** daß die Düsen Hohlnadeln sind.

11. Vorrichtung zur Durchführung eines Verfahrens nach einem der Ansprüche 1 bis 7, dadurch gekennzeichnet, daß die UV-Lichtquelle zwei Lichtleiter enthält, deren Enden jeweils oberhalb der Zwischenschichtebenen positioniert sind und jeweils einen gegen die Zwischenschichtebene ge- neigten Lichtstrahl abgeben.

# FIG 1

# FIG 2

# FIG 3